(19) Europäisches Patentamt / European Patent Office / Office européen des brevets

(11) **EP 3 715 888 B1**

(12) **EUROPEAN PATENT SPECIFICATION**

(45) Date of publication and mention
of the grant of the patent:
**13.09.2023 Bulletin 2023/37**

(21) Application number: **18878076.1**

(22) Date of filing: **19.11.2018**

(51) International Patent Classification (IPC):
$G01R\ 31/36$ (2020.01)　　$G01R\ 31/367$ (2019.01)
$H02J\ 7/00$ (2006.01)　　$G01R\ 31/387$ (2019.01)
$G01R\ 31/371$ (2019.01)

(52) Cooperative Patent Classification (CPC):
**G01R 31/367; G01R 31/3648; G01R 31/371**

(86) International application number:
**PCT/CN2018/116128**

(87) International publication number:
**WO 2019/096296 (23.05.2019 Gazette 2019/21)**

(54) **METHOD, DEVICE AND SYSTEM FOR CALCULATING SOC OF BATTERY ON BASIS OF CHARGING STATUS OF CHARGING SIDE**

VERFAHREN, VORRICHTUNG UND SYSTEM ZUM BERECHNEN DES LADEZUSTANDS EINER BATTERIE AUF DER BASIS DES LADESTATUS DER LADESEITE

PROCÉDÉ, DISPOSITIF ET SYSTÈME POUR CALCULER UN ÉTAT DE CHARGE DE BATTERIE SUR LA BASE DU STATUT DE CHARGE D'UN CÔTÉ DE CHARGE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.11.2017 CN 201711154222**

(43) Date of publication of application:
**30.09.2020 Bulletin 2020/40**

(73) Proprietor: **NIO (Anhui) Holding Co., Ltd.**
**Hefei City, Anhui Province (CN)**

(72) Inventors:
 • **CHEN, Jiong**
  **Anting, Jiading, Shanghai (CN)**
 • **HAO, Tianlei**
  **Anting, Jiading, Shanghai (CN)**
 • **DAI, Chensong**
  **Anting, Jiading, Shanghai (CN)**

(74) Representative: **Vossius & Partner**
**Patentanwälte Rechtsanwälte mbB**
**Siebertstrasse 3**
**81675 München (DE)**

(56) References cited:
AU-A1- 2016 201 173　　CN-A- 102 520 366
CN-A- 105 093 121　　CN-A- 107 064 800
CN-A- 107 064 800　　CN-A- 108 226 788
KR-A- 20160 063 070　　KR-A- 20160 063 070

• SHAO SAI ET AL: "On-line estimation of state-of-charge of Li-ion batteries in electric vehicle using the resampling particle filter", TRANSPORTATION RESEARCH PART D: TRANSPORT AND ENVIRONMENT, PERGAMON, AMSTERDAM, NL, vol. 32, 29 August 2014 (2014-08-29), pages 207-217, XP029047601, ISSN: 1361-9209, DOI: 10.1016/J.TRD.2014.07.013
• SHAO, SAI et al.: "On-Line Estimation of State-of-Charge of Li-ion Batteries in Electric Vehicle Using the Resampling Particle Filter", Transportation Research Part D, vol. 32, 31 October 2014 (2014-10-31), pages 207-217, XP029047601, DOI: doi:10.1016/j.trd.2014.07.013

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### Technical Field

The invention relates to the technical field of battery management, and particularly relates to a method, device and system for calculating an SOC of a battery on the basis of a charging state of a charging side.

### Background Art

With the development of battery technologies, electric vehicles are becoming more and more popular. In order to meet charging demands of electric vehicles and reduce negative impacts of charging of the electric vehicles on power grids when the electric vehicles are connected to the power grids for charging, AC charging pile groups are needed to charge the electric vehicles in an orderly manner. Orderly charging refers to using practical and effective technical means to control the charging of electric vehicles in the case of meeting the charging demands of the electric vehicles, to perform peak-load shifting on load curves of the power grids, so as to ensure coordinated and interactive development between the electric vehicles and the power grids. In order to achieve the above objective, only after acquiring state of charge (SOC) information of the electric vehicles, can charging piles coordinate power distributions and decide whether to continue to charge the electric vehicles corresponding to the AC charging piles, wherein the SOC information refers to a ratio of a remaining electric quantity to a total battery capacity.

CN 107 064 800 A discloses a real-time prediction method of the remaining lifetime of a lithium-ion battery. The method comprises a step of establishing a lithium ion battery capacity degradation model, a step of selecting prior distribution of suitable lithium ion battery capacity degradation model parameters, a step of selecting a likelihood function of the suitable lithium ion battery capacity degradation model parameters, a step of calculating the posterior distribution of the lithium ion battery capacity degradation model parameters based on the Bayesian theory, a step of calculating the prediction distribution of a lithium ion battery capacity, and a step of finally calculating and obtaining the remaining lifetime of a lithium ion battery to be predicted and confidence.

KR 2016 0063070 A discloses an apparatus and a method for estimating a battery state. In particular, it relates to the technology of estimating the state of charging of battery of an electric automobile by using changes in a curved type of charging voltage. it comprises: a feature extraction unit which extracts the feature of a change in a curve type of voltage corresponding to the time of charging a battery and sets up a feature vector; a classification unit which classifies a category pertaining to the feature vector extracted by the feature extraction unit through an ex post facto probability; and a battery state estimation unit which calculates an estimation for the state of charging of battery in response to the output of a classification unit and estimates the state of battery by comparing the estimation with the detected estimation.

However, an existing national standard does not support directly acquiring of SOC information of a vehicle from an AC charging pile side. Charging current information of the electric vehicle can be obtained by the AC charging pile side only through detecting a duty cycle of a pulse width modulation (PWM) signal between the AC charging pile side and an on board charger, while the SOC information of the electric vehicle cannot be obtained directly. If the AC charging pile side desires to directly acquire the SOC information of the electric vehicle, it is required to establish a communication link between the electric vehicle and the AC charging pile. However, establishing the communication link requires hardware matching between the electric vehicle and the AC charging pile and formulation of a consistent communication protocol, as well as formulation of a consistent interaction protocol between operation networks of the electric vehicle and the AC charging pile, while the existing electric vehicle and the existing AC charging pile cannot match in hardware, and lack a consistent communication protocol, and the operation networks of the two do not have a consistent interaction protocol either.

Therefore, how to propose a solution to the above problems is a problem that those skilled in the art need to solve at present.

### Summary of the Invention

In order to solve the above problem, i.e., to solve a problem in the prior art that an SOC of a rechargeable battery cannot be acquired by using information of a charging side, an aspect of the invention provides a method for calculating an SOC of a battery on the basis of a charging state of a charging side as defined in claim 1.

The invention further features a system as defined in claim 8, a storage device as defined in claim 10 and a processing device as defined in claim 11. Embodiments of the invention are disclosed in the dependent claims.

The above technical solution has at least the following beneficial effects: According to the method for calculating the SOC of the battery on the basis of the charging state of the charging side provided in the invention, the electrical parameter of the specific electrical component can be acquired from the charging side on the basis of the existing hardware and system architecture of the charging side and the rechargeable battery, so as to reversely deduce the current SOC of the rechargeable battery, without needing to establish an additional communication connection between the rechargeable battery and the charging side, which reduces the cost of modifying the hardware of the rechargeable battery and the charging side, and is efficient and fast. In addition, after acquiring the SOC information of the rechargeable battery on the charging side, the rechargeable battery can be charged in an orderly manner, which reduces a voltage load on a power grid and effectively improves the charging efficiency of the rechargeable battery.

## Brief Description of the Drawings

FIG. 1 is a schematic flowchart of a method for calculating an SOC of a battery on the basis of a charging state of a charging side in an embodiment of the invention;
FIG. 2 is a schematic structural diagram of a connection between a charging side and a rechargeable vehicle in an embodiment of the invention; and
FIG. 3 is a schematic structural diagram of a system for calculating an SOC of a battery on the basis of a charging state of a charging side in an embodiment of the invention.

## Detailed Description of Embodiments

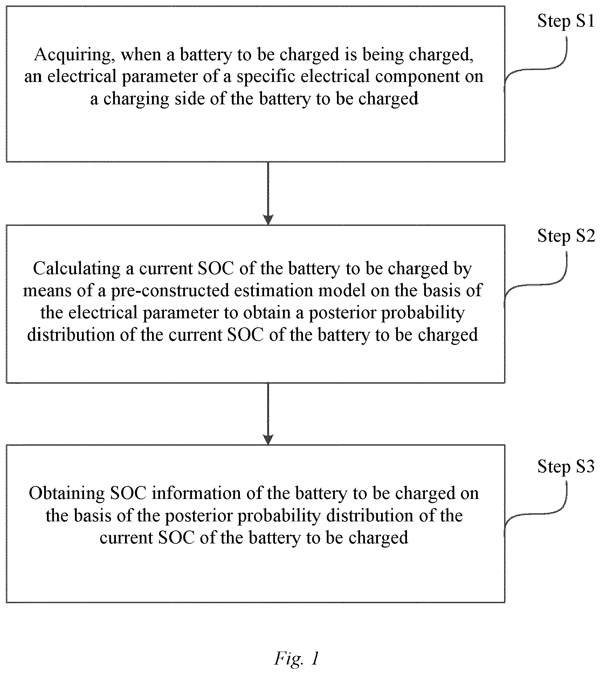

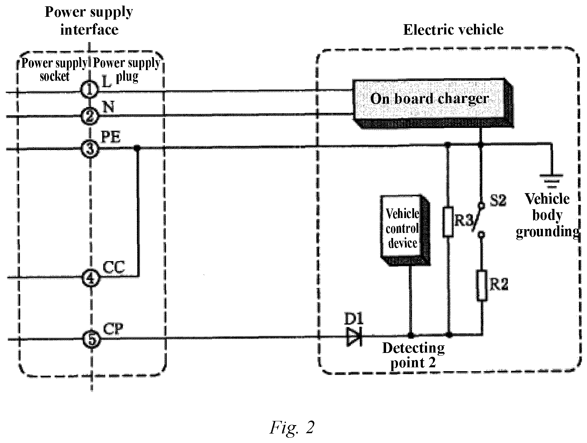

To make the objectives, technical solutions, and advantages of the embodiments of the invention clearer, the technical solutions in the embodiments of the invention will be described clearly and completely with reference to the accompanying drawings in the embodiments of the invention.
Preferred embodiments of the invention are described below with reference to the accompanying drawings. It should be understood by those skilled in the art that these embodiments are only for explaining the technical principles of the invention and are not intended to limit the scope of protection of the invention.
Referring to FIG. 1, FIG. 1 exemplarily shows a schematic flowchart of a method for calculating an SOC of a battery on the basis of a charging state of a charging side in an embodiment. As shown in FIG. 1, the method for calculating the SOC of the battery on the basis of the charging state of the charging side in this embodiment comprises the following steps:
Step S 1: acquiring, when a battery to be charged is being charged, an electrical parameter of a specific electrical component on the charging side of the battery to be charged;
In practical applications, the charging side is an AC charging pile, and the battery to be charged is a traction battery on an electric vehicle. Of course, the charging side and the battery to be charged may also be a charging device of a battery swap station and an energy storage battery, or another charging apparatus of a storage battery and the storage battery. Referring to FIG. 2, FIG. 2 exemplarily shows a schematic structural diagram of a connection between a charging side and a rechargeable vehicle in an embodiment. According to the existing national standard, the charging side is provided with a specific electrical component, and a specific electrical parameter of the electrical component changes with the change of an SOC of a battery to be charged. Therefore, it is possible to reversely deduce SOC information of the battery to be charged by acquiring the electrical parameter of the specific electrical component. Specifically, charging current information and change curves requested by the battery to be charged can be obtained by the AC charging pile through detecting a duty cycle of a pulse width modulation (PWM) signal between the AC charging pile and an on board charger of the rechargeable vehicle. When the rechargeable vehicle is connected to the AC charging pile, other input parameters may be obtained by the AC charging pile.
There are usually a plurality of AC charging piles, and the plurality of AC charging piles are connected to a power grid as a whole. The plurality of AC charging piles are referred to as an AC charging pile group. In order to ensure a normal state of charge of the power grid, the power grid distributes a certain amount of charges to the AC charging pile group, the AC charging pile group distributes the charges distributed from the power grid to the rechargeable batteries of connected rechargeable vehicles, and the AC charging pile group can accurately, efficiently and in real time distribute charges satisfying conditions to the batteries to be charged of the rechargeable vehicles after directly obtaining state of charge (SOC) information of the rechargeable vehicles on the AC charging pile side.
Further, referring to FIG. 2, FIG. 2 exemplarily shows the schematic structural diagram of the connection between the charging side and the rechargeable vehicle in this embodiment. In this embodiment, the electrical parameter of the specific electrical component in step S1 shown in FIG. 1 refers to the charging current, a line-to-line resistance set between connecting lines of output ports on the charging side, a continuous charging time of the vehicle, and an output voltage of an on board charger (OBC). The line-to-line resistance here is a resistance between protective grounding PE and control protection CP on the charging side, or a resistance between L and N. The charging current is obtained by a PWM signal receiving end on the charging side by analyzing a PWM signal of the rechargeable battery.
In a preferred implementation solution of this embodiment, the method for acquiring the charging current comprises:

obtaining, by a PWM signal receiving end on the charging side, the charging current by analyzing a PWM signal of the battery to be charged.

In this embodiment, when different types of rechargeable batteries leave factory, electrical parameters of specific electrical components on charging sides of the rechargeable batteries in different SOCs are tested. As a preferred implementation solution of this embodiment, taking the rechargeable battery as an example, when the rechargeable battery leaves factory, a conditional probability model of the rechargeable battery in different SOCs may be established by means of a big data method. After an electric vehicle is connected to the charging side, the PWM signal receiving end on the charging side receives a duty cycle of a PWM signal between the charging side and the on board charger of the rechargeable vehicle, analyzes the duty cycle of the PWM signal to obtain the charging current requested by the rechargeable battery, and reversely deduces an SOC prior probability distribution corresponding to a current charging current according to the conditional probability model of the charging currents of the rechargeable battery in different SOCs.

Step S2: a current SOC of the battery to be charged is calculated by means of a pre-constructed estimation model on the basis of the electrical parameter to obtain a posterior probability distribution of the current SOC of the battery to be charged,

wherein the estimation model is the posterior probability distribution of the battery to be charged with respect to a charging current demand and the electrical parameter of the specific electrical component on the charging side.

On the basis of step S 1, after the electrical parameter on the charging side of the battery to be charged is obtained, the electrical parameter is input into the pre-constructed estimation model to calculate the current SOC of the battery to be charged on the basis of the current electrical parameter to obtain the posterior probability distribution of the current SOC of the battery to be charged.

Further, in this embodiment, the method for constructing the estimation model in step S2 shown in FIG. 1 specifically comprises:

constructing a first conditional probability model of charging currents of the battery to be charged in different SOCs and a second conditional probability model of the electrical parameters on the basis of charging current demands of the battery to be charged in different SOCs and the corresponding electrical parameters of the specific electrical component on the charging side in historical data;

acquiring the charging current demands of the battery to be charged in different SOCs and the electrical parameters on the basis of the historical data, and obtaining a first prior probability and a second prior probability respectively according to the first conditional probability model and the second conditional probability model; and

constructing the posterior probability distribution of the battery to be charged with respect to the charging current demand and the electrical parameter of the specific electrical component on the charging side by means of a Bayes formula on the basis of the first prior probability and the second prior probability, and taking the posterior probability distribution as the estimation model.

In this embodiment, the method for constructing the first conditional probability model of the charging current demands of the battery to be charged in different SOCs is as follows: when vehicles with different types of batteries to be charged leave factory, charging currents of the batteries to be charged in different SOCs are tested. For example, starting from an SOC of 1%, and increasing by one percentage point at a time until the SOC is 100%, the charging currents of the batteries to be charged in all SOCs are tested. The conditional probability model of the charging currents of the batteries to be charged in different SOCs is established by means of a big data method, and the conditional probability model is taken as the first conditional probability model.

Similarly, the method for constructing the second conditional probability model of the electrical parameters of the battery to be charged in different SOCs is as follows: when vehicles with different types of batteries to be charged leave factory, values of electrical parameters of the batteries to be charged in different SOCs are tested. For example, starting from an SOC of 1%, and increasing by one percentage point at a time until the SOC is 100%, the values of the specific electrical parameters in all SOCs are tested. The conditional probability model of the specific electrical parameters of the batteries to be charged in different SOCs is established by means of a big data method, and the conditional probability model is taken as the second conditional probability model.

After the charging currents and the electrical parameters in different SOCs are obtained, the charging currents and the electrical parameters are respectively input into the first conditional probability model and the second conditional probability model, such that the first prior probability and the second prior probability can be obtained respectively. Taking the first conditional probability model and the first prior probability as an example, after charging current information is obtained, an SOC prior probability distribution corresponding to a current charging current can be reversely deduced according to a pre-established relationship between a charging current and an SOC in the first conditional probability model, and taken as a first prior probability. The second conditional probability model and the second prior probability can be obtained with the same method, which will not be repeated here.

Step S3: the SOC of the battery to be charged is obtained on the basis of the posterior probability distribution of the current SOC of the battery to be charged.

Further, in this embodiment, the step for obtaining the SOC on the basis of the posterior probability distribution of the current SOC of the battery to be charged in step S3 shown in FIG. 1 specifically comprises:

calculating a mathematical expectation or maximum likelihood estimation of the posterior probability distribution of the current SOC of the battery to be charged, and taking a calculating result as the SOC of the battery to be charged.

In this embodiment, the posterior probability distribution of the SOC obtained by means of the estimation model is only a distribution interval of the SOC. In order to obtain the exact SOC of the battery to be charged, the obtained posterior probability distribution of the SOC needs to be further calculated.

In probability theory and statistics, the mathematical expectation refers to a sum of a probability of each possible result in an experiment multiplied by the result, reflecting an average value of a random variable. The maximum likelihood estimation is an approximate value of a specific parameter deduced by using the result of observing several experiments done when a certain random sample satisfies a certain probability distribution, but the parameter in the random sample is not clear. In practical applications, the current SOC of the rechargeable vehicle can be calculated by either of the above two methods. In addition to the above two methods, other methods may also be used, which are not limited here.

According to the method for calculating the SOC of the battery on the basis of the charging state of the charging side provided in the invention, the electrical parameter of the specific electrical component can be acquired from the charging side on the basis of the existing hardware and system architecture of the charging side and the rechargeable battery, so as to reversely deduce the current SOC of the rechargeable battery, without needing to establish an additional communication connection between the rechargeable battery and the charging side, which reduces the cost of modifying the hardware of the rechargeable battery and the charging side, and is efficient and fast. In addition, after acquiring the SOC information of the rechargeable battery on the charging side, the rechargeable battery can be charged in an orderly manner, which reduces a voltage load on a power grid and effectively improves the charging efficiency of the rechargeable battery.

In a preferred implementation solution of this embodiment, the method for obtaining the first prior probability further comprises:

making statistics on SOC distributions corresponding to charging currents of the battery to be charged from a to-be-charged state to a fully charged state; and
calculating an average distribution of the SOC distributions corresponding to the charging current demands, and taking the average distribution as the first prior probability.

In this embodiment, after the battery to be charged is connected to the charging side, statistics on the SOC distributions corresponding to the charging currents from the to-be-charged state to the fully charged state are made, wherein the to-be-charged state may be that an electric quantity of the battery to be charged is 20% of a total electric quantity, and the fully charged state may be that the electric quantity of the battery to be charged is 95% of the total electric quantity. The average distribution of the SOC distributions corresponding to the charging currents may be calculated, such that a uniform distribution of the SOCs from the to-be-charged state to the fully charged state can be obtained, and taken as the first prior probability.

In a preferred implementation solution of this embodiment, the method for constructing the posterior probability distribution by means of the Bayes formula comprises:

substituting the first prior probability and the second prior probability into the Bayes formula to construct the posterior probability distribution, wherein the Bayes formula is as shown in formula (1):

$$P\left(B_i \middle| A\right) = \frac{P\left(B_i\right) P\left(A \middle| B_i\right)}{\sum_{j=1}^{n} P\left(B_j\right) P\left(A \middle| B_j\right)} \qquad (1)$$

where $P(B_i)$ is the first prior probability, $P(A|B_i)$ is the second prior probability, the variable $B_i$ is SOC information of the battery to be charged, the variable $A$ is the electrical parameter of the specific electrical component, and the variable $n$ is a preset threshold of the SOC of the battery to be charged that is obtained after discrete quantization.

After the first prior probability and the second prior probability are obtained, the two are substituted into the Bayes formula to estimate the SOC. A problem of inferring a probability of the occurrence of an underlying law of data from the measured data can be solved by means of the Bayes formula. In the formula, a probability of the occurrence of an event $B_i$ is $P(B_i)$, and under the condition that the event $B_i$ has occurred, a probability of the occurrence of an event $A$ is $P(A|B_i)$. With reference to practical application scenarios of the invention, taking the event $A$ being a charging current I requested by a battery to be recharged, and a resistance R between AC charging pile PE and CP as an example, and taking the event $B_i$ being an SOC prior probability of the battery to be charged as an example, an SOC conditional probability density of the battery to be charged under current observable conditions is solved, which is as shown in formula (2):

$$P\left(SOC\middle| I, R\right) = \frac{P\left(SOC\right) P\left(I, R\middle| SOC\right)}{\sum_{j=1}^{n} P\left(SOC_j\right) P\left(I, R\middle| SOC_j\right)} \qquad (2)$$

where $P(SOC)$ is an SOC prior probability of batteries to be charged of all the rechargeable vehicles connected to a charging side, $P(I, R|SOC)$ is a conditional probability density distribution when electrical parameters are I and R in a known specific SOC, and the specific SOC may be preset or set by a user according to a user's requirements, for example, the specific SOC may be 70%. $n$ is a preset threshold of a distribution interval of the SOC of the battery to be charged of the rechargeable vehicle that is obtained after discrete quantization. In practical applications, values may be taken according to the user's requirements and different precision requirements, for example, $n$ may be 100, and this covers all SOC values. By substituting the SOC prior probability density distribution and the conditional probability density distribution for the electrical parameters into the Bayes formula, the SOC conditional probability density in the case of the current electrical parameters can be obtained.

In a preferred implementation solution of this embodiment, before said constructing the posterior probability distribution by means of a Bayes formula on the basis of the first prior probability and the second prior probability, the method further comprises:

introducing a vehicle type of the battery to be charged into the electrical parameter, and adding the vehicle type of the rechargeable battery as a variable to the Bayes formula, wherein the Bayes formula obtained after the vehicle type is added is specifically as follows:

$$P\left(B_i, C\middle| A\right) = \frac{P\left(B_i, C\right) P\left(A\middle| B_i, C\right)}{\sum_{i=1}^{k} \sum_{j=1}^{n} P\left(B_j, C_i\right) P\left(A\middle| B_j, C_i\right)},$$

where the variable C is the vehicle type of the battery to be charged, and the variable k is a sum of the vehicle types of the batteries to be charged.

In this embodiment, taking the electrical parameters being the charging current I requested by the battery to be charged of the rechargeable vehicle and the resistance R between the charging side PE and the CP as an example, in practical applications, values of the above two are related to the type of the rechargeable vehicle and even a type of a battery pack of the rechargeable vehicle; therefore, the type of the rechargeable vehicle is also a variable that affects SOC estimation information of the battery to be charged of the rechargeable vehicle, which is added to the electrical parameters of the rechargeable vehicle. After adding the type of the vehicle, the SOC conditional probability density of the battery to be charged of the rechargeable vehicle in the case of the current electrical parameter is solved, which is as shown in formula (3):

$$P\left(SOC, C\middle| I, R\right) = \frac{P\left(SOC, C\right) P\left(I, R\middle| SOC, C\right)}{\sum_{i=1}^{k} \sum_{j=1}^{n} P\left(SOC_j, C_i\right) P\left(I, R\middle| SOC_j, C_i\right)} \qquad (3)$$

The calculating method is the same as that in formula (2), and will not be repeated here. The variable $k$ in formula (3) is a sum of the types of the rechargeable vehicles connected to the charging side. However, in practical applications, if the charging side may not be able to obtain the type of the connected rechargeable vehicle, integration and summing may be performed on the types of the vehicles once, which is as shown in formula (4):

$$P\left(SOC\middle|I,R\right) = \sum_{i=1}^{k} P\left(SOC, C_i\middle|I,R\right) \qquad (4)$$

By performing integration and summing on the types of the vehicles once, a two-dimensional probability distribution may be converted into a one-dimensional probability distribution, which reduces one variable and is easier to solve.

According to the method for calculating the SOC of the battery on the basis of the charging state of the charging side provided in the invention, the electrical parameter of the specific electrical component can be acquired from the charging side on the basis of the existing hardware and system architecture of the charging side and the rechargeable battery, so as to reversely deduce the current SOC of the rechargeable battery, without needing to establish an additional communication connection between the rechargeable battery and the charging side, which reduces the cost of modifying the hardware of the rechargeable battery and the charging side, and is efficient and fast. In addition, after acquiring the SOC information of the rechargeable battery on the charging side, the rechargeable battery can be charged in an orderly manner, which reduces a voltage load on a power grid and effectively improves the charging efficiency of the rechargeable battery.

The method or algorithm steps described with reference to the embodiments disclosed herein may be implemented by hardware, a software module executed by a processor, or a combination of both. Software modules may be disposed in a random access memory (RAM), a memory, a read-only memory (ROM), an electrically programmable ROM, an electrically erasable programmable ROM, a register, a hard disk, a removable disk, a CD-ROM, or any other form of storage medium known in the technical field.

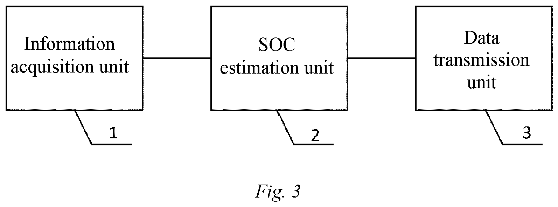

Referring to FIG. 3, FIG. 3 exemplarily shows a schematic structural diagram of a system for calculating an SOC of a battery on the basis of a charging state of a charging side in an embodiment. As shown in FIG. 3, the system for estimating the SOC on the basis of the AC charging pile in this embodiment comprises:

an information acquisition unit 1 configured to acquire, when a battery to be charged is being charged, an electrical parameter of a specific electrical component on the charging side of the battery to be charged;

an SOC calculation unit 2 configured to calculate a current SOC of the battery to be charged by means of a pre-constructed estimation model on the basis of the electrical parameter to obtain a posterior probability distribution of the current SOC of the battery to be charged; and obtain SOC information of the battery to be charged on the basis of the posterior probability distribution of the current SOC of the battery to be charged; and

a data transmission unit 3 configured to transmit the information acquired by the information acquisition unit 1 to the SOC calculation unit 2 and transmit the SOC information calculated by the SOC calculation unit 2 to an AC charging pile,

wherein the estimation model is the posterior probability distribution of the battery to be charged with respect to a charging current and the electrical parameter of the specific electrical component on the charging side.

In a preferred technical solution of this embodiment, the method for constructing the estimation model comprises:

constructing a first conditional probability model of charging current demands of the battery to be charged in different SOCs and a second conditional probability model of the electrical parameters on the basis of the charging currents of the battery to be charged in different SOCs and the corresponding electrical parameters of the specific electrical component on the charging side in historical data;

acquiring the charging current demands of the battery to be charged in different SOCs and the electrical parameters on the basis of the historical data, and obtaining a first prior probability and a second prior probability respectively according to the first conditional probability model and the second conditional probability model; and

constructing the posterior probability distribution of the battery to be charged with respect to the charging current and the electrical parameter of the specific electrical component on the charging side by means of a Bayes formula on the basis of the first prior probability and the second prior probability, and taking the posterior probability distribution as the estimation model.

It will be clearly understood by those skilled in the art that for the convenience and brevity of the description, for the specific working process and related description of the system for calculating the SOC of the battery on the basis of the charging state of the charging side in the embodiment of the invention, reference may be made to the corresponding process in the above-mentioned embodiment of the method for calculating the SOC of the battery on the basis of the charging state of the charging side, which have the same beneficial effects as the above method, and will not be repeated here.

Based on the above embodiment of the method for calculating the SOC of the battery on the basis of the charging state of the charging side, the invention also provides a storage device in which a plurality of programs are stored, wherein the programs are adapted to be loaded and executed by a processor to implement the method for calculating the SOC of the battery on the basis of the charging state of the charging side described above.

It will be clearly understood by those skilled in the art that for the convenience and brevity of the description, for the specific working process and related description of the storage device in the embodiment of the invention, reference may be made to the corresponding process in the above-mentioned embodiment of the method for calculating the SOC of the battery on the basis of the charging state of the charging side, which have the same beneficial effects as the above method, and will not be repeated here.

Based on the above embodiment of the method for calculating the SOC of the battery on the basis of the charging state of the charging side, the invention also provides a processing device, comprising a processor and a storage apparatus; the processor being adapted to execute various programs; and the storage apparatus being adapted to store a plurality of programs, wherein the programs being adapted to be loaded and executed by the processor to implement the method for calculating the SOC of the battery on the basis of the charging state of the charging side described above.

It will be clearly understood by those skilled in the art that for the convenience and brevity of the description, for the specific working process and related description of the processing device in the embodiment of the invention, reference may be made to the corresponding process in the above-mentioned embodiment of the method for estimating the SOC on the basis of the AC charging pile, which have the same beneficial effects as the above method, and will not be repeated here.

Those skilled in the art should be able to realize that the method steps of the various examples described with reference to the embodiments disclosed herein can be implemented in electronic hardware, computer software or a combination of both. To clearly illustrate the interchangeability of electronic hardware and software, the compositions and steps of the various examples have been generally described in terms of functionality in the above description. Whether these functions are performed in electronic hardware or software depends on the specific application and design constraints of the technical solution. Those skilled in the art can use different methods to implement the described functions for each particular application, but such implementation should not be considered to be beyond the scope of the invention.

Heretofore, the technical solutions of the invention have been described with reference to the preferred embodiments shown in the accompanying drawings; however, those skilled in the art can readily understand that the scope of protection of the invention is obviously not limited to these particular embodiments.

**Claims**

1. A method for calculating a state of charge SOC of a battery on the basis of a charging state of a charging side, the method comprising:

   acquiring, when a battery to be charged is being charged, an electrical parameter of a specific electrical component on the charging side of the battery to be charged (S1);
   calculating a current SOC of the battery to be charged by means of a pre-constructed estimation model on the basis of the electrical parameter to obtain a posterior probability distribution of the current SOC of the battery to be charged (S2); and
   obtaining the SOC of the battery to be charged on the basis of the posterior probability distribution of the current SOC of the battery to be charged (S3),
   wherein
   the estimation model is the posterior probability distribution of the battery to be charged with respect to a charging current and the electrical parameter of the specific electrical component on the charging side;
   **characterised in that** the
   electrical parameter of the specific electrical component comprises the charging current, and a resistance between protective grounding and control protection on the charging side.

2. The method for calculating the SOC of the battery on the basis of the charging state of the charging side according to claim 1, **characterized in that** the method for constructing the estimation model comprises:

constructing a first conditional probability model of charging currents of the battery to be charged in different SOCs and a second conditional probability model of the electrical parameters on the basis of the charging currents of the battery to be charged in different SOCs and the corresponding electrical parameters of the specific electrical component on the charging side in historical data;
acquiring the charging currents of the battery to be charged in different SOCs and the electrical parameters on the basis of the historical data, and obtaining a first prior probability and a second prior probability respectively according to the first conditional probability model and the second conditional probability model; and
constructing the posterior probability distribution of the battery to be charged with respect to the charging current and the electrical parameter of the specific electrical component on the charging side by means of a Bayes formula on the basis of the first prior probability and the second prior probability, and taking the posterior probability distribution as the estimation model.

3. The method for calculating the SOC of the battery on the basis of the charging state of the charging side according to claim 2, **characterized in that** the method for obtaining the first prior probability further comprises:

making statistics on SOC distributions corresponding to charging currents of the battery to be charged from a to-be-charged state to a fully charged state; and
calculating an average distribution of the SOC distributions corresponding to the charging currents, and taking the average distribution as the first prior probability.

4. The method for calculating the SOC of the battery on the basis of the charging state of the charging side according to claim 3, **characterized in that** the method for constructing the posterior probability distribution by means of the Bayes formula comprises:

substituting the first prior probability and the second prior probability into the Bayes formula to construct the posterior probability distribution, wherein the Bayes formula is specifically as follows:

$$P\left(B_i\middle|A\right) = \frac{P\left(B_i\right)P\left(A\middle|B_i\right)}{\sum_{j=1}^{n}P\left(B_j\right)P\left(A\middle|B_j\right)},$$

where $P(B_i)$ is the first prior probability, $P(A|B_i)$ is the second prior probability, the variable $B_i$ is SOC information of the battery to be charged, the variable $A$ is the electrical parameter of the specific electrical component, and the variable $n$ is a preset threshold of the SOC of the battery to be charged that is obtained after discrete quantization.

5. The method for calculating the SOC of the battery on the basis of the charging state of the charging side according to claim 1, **characterized in that** the method for "obtaining the SOC of the battery to be charged on the basis of the posterior probability distribution of the current SOC of the battery to be charged(S3)" comprises:
calculating a mathematical expectation or maximum likelihood estimation of a posterior probability density distribution of the current SOC of the battery to be charged, and taking a calculating result as the SOC of the battery to be charged.

6. The method for calculating the SOC of the battery on the basis of the charging state of the charging side according to claim 1, **characterized in that** the method for acquiring the charging current comprises:
obtaining, by a PWM signal receiving end on the charging side, the charging current by analyzing a PWM signal of the battery to be charged.

7. The method for calculating the SOC of the battery on the basis of the charging state of the charging side according to any one of claims 1 to 6, **characterized in that** before said constructing the posterior probability distribution by means of a Bayes formula on the basis of the first prior probability and the second prior probability, the method further comprises:

introducing a vehicle type of the battery to be charged into the electrical parameter, and adding the vehicle type of the battery to be charged as a variable to the Bayes formula, wherein the Bayes formula obtained after the vehicle type is added is specifically as follows:

$$P\left(B_i, C \mid A\right) = \frac{P\left(B_i, C\right) P\left(A \mid B_i, C\right)}{\sum_{i=1}^{k} \sum_{j=1}^{n} P\left(B_j, C_i\right) P\left(A \mid B_j, C_i\right)},$$

where the variable C is the vehicle type of the battery to be charged, and the variable k is a sum of the vehicle types of the batteries to be charged.

8. A system for calculating an SOC of a battery on the basis of a charging state of a charging side, comprising:

an information acquisition unit (1) configured to acquire, when a battery to be charged is being charged, an electrical parameter of a specific electrical component on the charging side of the battery to be charged; an SOC calculation unit (2) configured to calculate a current SOC of the battery to be charged by means of a pre-constructed estimation model on the basis of the electrical parameter to obtain a posterior probability distribution of the current SOC of the battery to be charged; and obtain SOC information of the battery to be charged on the basis of the posterior probability distribution of the current SOC of the battery to be charged; and a data transmission unit (3) configured to transmit the information acquired by the information acquisition unit (1) to the SOC calculation unit (2) and transmit the SOC information calculated by the SOC calculation unit (2) to an AC charging pile, wherein the estimation model is the posterior probability distribution of the battery to be charged with respect to a charging current and the electrical parameter of the specific electrical component on the charging side; **characterised in that** the electrical parameter of the specific electrical component comprises the charging current, and a resistance between protective grounding and control protection on the charging side.

9. The system for calculating the SOC of the battery to be charged on the basis of the charging state of the charging side according to claim 8, **characterized in that** the method for constructing the estimation model comprises:

constructing a first conditional probability model of charging currents of the battery to be charged in different SOCs and a second conditional probability model of the electrical parameters on the basis of the charging currents of the battery to be charged in different SOCs and the corresponding electrical parameters of the specific electrical component on the charging side in historical data; acquiring the charging currents of the battery to be charged in different SOCs and the electrical parameters on the basis of the historical data, and obtaining a first prior probability and a second prior probability respectively according to the first conditional probability model and the second conditional probability model; and constructing the posterior probability distribution of the battery to be charged with respect to the charging current and the electrical parameter of the specific electrical component on the charging side by means of a Bayes formula on the basis of the first prior probability and the second prior probability, and taking the posterior probability distribution as the estimation model.

10. A storage device in which a plurality of programs are stored, **characterized in that** the programs are adapted to be loaded and executed by a processor to implement the method for calculating the SOC of the battery on the basis of the charging state of the charging side according to any one of claims 1 to 7.

11. A processing device, comprising a processor and a storage apparatus; the processor being adapted to execute various programs; and the storage apparatus being adapted to store a plurality of programs, **characterized in that** the programs are adapted to be loaded and executed by the processor to implement the method for calculating the SOC of the battery on the basis of the charging state of the charging side according to any one of claims 1 to 7.

**Patentansprüche**

1. Verfahren zum Berechnen eines Ladezustands SOC einer Batterie auf der Grundlage eines Ladezustands einer Ladeseite, wobei das Verfahren aufweist:

Erfassen eines elektrischen Parameters einer spezifischen elektrischen Komponente auf der Ladeseite der zu ladenden Batterie (S1), wenn eine zu ladende Batterie geladen wird;

Berechnen eines aktuellen SOC der zu ladenden Batterie mittels eines vorab erstellten Schätzmodells auf der Grundlage des elektrischen Parameters, um eine A-posteriori-Wahrscheinlichkeitsverteilung des aktuellen SOC der zu ladenden Batterie (S2) zu erhalten; und

Erhalten des SOC der zu ladenden Batterie auf der Grundlage der A-Posteriori-Wahrscheinlichkeitsverteilung des aktuellen SOC der zu ladenden Batterie (S3),

wobei

das Schätzmodell die A-posteriori-Wahrscheinlichkeitsverteilung der zu ladenden Batterie in Bezug auf einen Ladestrom und den elektrischen Parameter der spezifischen elektrischen Komponente auf der Ladeseite ist;

**dadurch gekennzeichnet, dass** der

elektrische Parameter der spezifischen elektrischen Komponente den Ladestrom und einen Widerstand zwischen Schutzerdung und Steuerschutz auf der Ladeseite aufweist.

2. Verfahren zum Berechnen des SOC der Batterie auf der Grundlage des Ladezustands der Ladeseite nach Anspruch 1, **dadurch gekennzeichnet, dass** das Verfahren zum Erstellen des Schätzmodells aufweist:

Erstellen eines ersten bedingten Wahrscheinlichkeitsmodells der Ladeströme der zu ladenden Batterie in verschiedenen SOCs und eines zweiten bedingten Wahrscheinlichkeitsmodells der elektrischen Parameter auf der Grundlage der Ladeströme der zu ladenden Batterie in verschiedenen SOCs und der entsprechenden elektrischen Parameter der spezifischen elektrischen Komponente auf der Ladeseite in historischen Daten;

Erfassen der Ladeströme der zu ladenden Batterie in verschiedenen SOCs und der elektrischen Parameter auf der Grundlage der historischen Daten und Erhalten einer ersten vorherigen Wahrscheinlichkeit bzw. einer zweiten vorherigen Wahrscheinlichkeit gemäß dem ersten bedingten Wahrscheinlichkeitsmodell und dem zweiten bedingten Wahrscheinlichkeitsmodell; und

Erstellen der A-posteriori-Wahrscheinlichkeitsverteilung der zu ladenden Batterie in Bezug auf den Ladestrom und den elektrischen Parameter der spezifischen elektrischen Komponente auf der Ladeseite mittels einer Bayes-Formel auf der Grundlage der ersten vorherigen Wahrscheinlichkeit und der zweiten vorherigen Wahrscheinlichkeit, und Verwenden der A-posteriori-Wahrscheinlichkeitsverteilung als Schätzmodell.

3. Verfahren zum Berechnen des SOC der Batterie auf der Grundlage des Ladezustands der Ladeseite nach Anspruch 2, **dadurch gekennzeichnet, dass** das Verfahren zum Erhalten der ersten vorherigen Wahrscheinlichkeit ferner aufweist:

Anfertigen von Statistiken über SOC-Verteilungen, die den Ladeströmen der zu ladenden Batterie von einem zu ladenden Zustand bis zu einem vollständig geladenen Zustand entsprechen; und

Berechnen einer Durchschnittsverteilung der SOC-Verteilungen, die den Ladeströmen entsprechen, und Aufnehmen der Durchschnittsverteilung als erste vorherige Wahrscheinlichkeit.

4. Verfahren zum Berechnen des SOC der Batterie auf der Grundlage des Ladezustands der Ladeseite nach Anspruch 3, **dadurch gekennzeichnet, dass** das Verfahren zum Erstellen der A-posteriori-Wahrscheinlichkeitsverteilung mittels der Bayes-Formel aufweist:

Ersetzen der ersten vorherigen Wahrscheinlichkeit und der zweiten vorherigen Wahrscheinlichkeit in die Bayes-Formel, um die A-posteriori-Wahrscheinlichkeitsverteilung zu erstellen, wobei die Bayes-Formel insbesondere wie folgt lautet:

$$P(B_i|A) = \frac{P(B_i)P(A|B_i)}{\sum_{j=i}^{n} P(B_j)P(A|B_j)}$$

wobei **$P(B_i)$** die erste vorherige Wahrscheinlichkeit ist, **$P(A|B_i)$** die zweite vorherige Wahrscheinlichkeit ist, die Variable **$B_i$** die SOC-Informationen der zu ladenden Batterie ist, die Variable **$A$** der elektrische Parameter der spezifischen elektrischen Komponente ist und die Variable **$n$** ein voreingestellter Schwellenwert des SOC der zu ladenden Batterie ist, der nach diskreter Quantisierung erhalten wird.

5. Verfahren zum Berechnen des SOC der Batterie auf der Grundlage des Ladezustands der Ladeseite nach Anspruch 1, **dadurch gekennzeichnet, dass** das Verfahren zum "Erhalten des SOC der zu ladenden Batterie auf der Grundlage der A-posteriori-Wahrscheinlichkeitsverteilung des aktuellen SOC der zu ladenden Batterie (S3)" aufweist:

Berechnen einer mathematischen Erwartung oder einer maximalen Wahrscheinlichkeitsschätzung einer A-posteriori-Wahrscheinlichkeitsdichteverteilung des aktuellen SOC der zu ladenden Batterie und Verwenden eines Berechnungsergebnisses als SOC der zu ladenden Batterie.

**6.** Verfahren zum Berechnen des SOC der Batterie auf der Grundlage des Ladezustands der Ladeseite nach Anspruch 1, **dadurch gekennzeichnet, dass** das Verfahren zum Erfassen des Ladestroms aufweist:
Erhalten des Ladestroms durch eine PWM-Signalempfangsseite auf der Ladeseite, durch Analysieren eines PWM-Signals der zu ladenden Batterie.

**7.** Verfahren zum Berechnen des SOC der Batterie auf der Grundlage des Ladezustands der Ladeseite nach einem der Ansprüche 1 bis 6, **dadurch gekennzeichnet, dass** vor dem Erstellen der A-posteriori-Wahrscheinlichkeitsverteilung mittels einer Bayes-Formel auf der Grundlage der ersten vorherigen Wahrscheinlichkeit und der zweiten vorherigen Wahrscheinlichkeit das Verfahren ferner aufweist:

Einführen eines Fahrzeugtyps der zu ladenden Batterie in den elektrischen Parameter, und Hinzufügen des Fahrzeugtyps der zu ladenden Batterie als eine Variable zu der Bayes-Formel, wobei die Bayes-Formel, die erhalten wird, nachdem der Fahrzeugtyp hinzugefügt wurde, insbesondere wie folgt lautet:

$$P(B_i, C \mid A) = \frac{P(B_i, C)P(A|B_i, C)}{\sum_{i=1}^{k} \sum_{j=1}^{n} P(B_j, C_i)P(A|B_j, C_i)}$$

wobei die Variable **C** der Fahrzeugtyp der zu ladenden Batterie ist und die Variable **k** eine Summe der Fahrzeugtypen der zu ladenden Batterien ist.

**8.** System zum Berechnen eines SOC einer Batterie auf der Grundlage eines Ladezustands einer Ladeseite, aufweisend:

eine Informationserfassungseinheit (1), die dazu ausgelegt ist, während des Ladens einer zu ladenden Batterie einen elektrischen Parameter einer spezifischen elektrischen Komponente auf der Ladeseite der zu ladenden Batterie zu erfassen;
eine SOC-Berechnungseinheit (2), die dazu ausgelegt ist, einen aktuellen SOC der zu ladenden Batterie mit Hilfe eines vorab erstellten Schätzmodells auf der Grundlage des elektrischen Parameters zu berechnen, um eine A-posteriori-Wahrscheinlichkeitsverteilung des aktuellen SOC der zu ladenden Batterie zu erhalten; und SOC-Informationen der zu ladenden Batterie auf der Grundlage der A-posteriori-Wahrscheinlichkeitsverteilung des aktuellen SOC der zu ladenden Batterie zu erhalten; und
eine Datenübertragungseinheit (3), die dazu ausgelegt ist, die von der Informationserfassungseinheit (1) erfassten Informationen an die SOC-Berechnungseinheit (2) zu übertragen und die von der SOC-Berechnungseinheit (2) berechneten SOC-Informationen an eine Wechselstrom-Ladesäule zu übertragen,
wobei das Schätzmodell die A-posteriori Wahrscheinlichkeitsverteilung der zu ladenden Batterie in Bezug auf einen Ladestrom und der elektrische Parameter der spezifischen elektrischen Komponente auf der Ladeseite ist;
**dadurch gekennzeichnet, dass** der
elektrische Parameter der spezifischen elektrischen Komponente den Ladestrom und einen Widerstand zwischen Schutzerdung und Steuerschutz auf der Ladeseite aufweist.

**9.** System zum Berechnen des SOC der zu ladenden Batterie auf der Grundlage des Ladezustands der Ladeseite nach Anspruch 8, **dadurch gekennzeichnet, dass** das Verfahren zum Erstellen des Schätzmodells aufweist:

Erstellen eines ersten bedingten Wahrscheinlichkeitsmodells der Ladeströme der zu ladenden Batterie in verschiedenen SOCs und eines zweiten bedingten Wahrscheinlichkeitsmodells der elektrischen Parameter auf der Grundlage der Ladeströme der zu ladenden Batterie in verschiedenen SOCs und der entsprechenden elektrischen Parameter der spezifischen elektrischen Komponente auf der Ladeseite in historischen Daten;
Erfassen der Ladeströme der zu ladenden Batterie in verschiedenen SOCs und der elektrischen Parameter auf der Grundlage der historischen Daten und Erhalten einer ersten vorherigen Wahrscheinlichkeit und einer zweiten vorherigen Wahrscheinlichkeit jeweils gemäß dem ersten bedingten Wahrscheinlichkeitsmodell und dem zweiten bedingten Wahrscheinlichkeitsmodell; und
Erstellen der A-posteriori Wahrscheinlichkeitsverteilung der zu ladenden Batterie in Bezug auf den Ladestrom und den elektrischen Parameter der spezifischen elektrischen Komponente auf der Ladeseite mittels einer Bayes-Formel auf der Grundlage der ersten vorherigen Wahrscheinlichkeit und der zweiten vorherigen Wahrscheinlichkeit, und Verwenden der A-posteriori-Wahrscheinlichkeitsverteilung als Schätzmodell.

10. Speichervorrichtung, in der eine Mehrzahl von Programmen gespeichert ist, **dadurch gekennzeichnet, dass** die Programme angepasst sind, um von einem Prozessor geladen und ausgeführt zu werden, um das Verfahren zur Berechnung des SOC der Batterie auf der Grundlage des Ladezustands der Ladeseite nach einem der Ansprüche 1 bis 7 zu implementieren.

11. Verarbeitungsvorrichtung, aufweisend einen Prozessor und eine Speichervorrichtung; wobei der Prozessor angepasst ist, um verschiedene Programme auszuführen; und die Speichervorrichtung angepasst ist, um eine Mehrzahl von Programmen zu speichern, **dadurch gekennzeichnet, dass** die Programme angepasst sind, um von dem Prozessor geladen und ausgeführt zu werden, um das Verfahren zum Berechnen des SOC der Batterie auf der Basis des Ladezustands der Ladeseite nach einem der Ansprüche 1 bis 7 zu implementieren.

**Revendications**

1. Procédé pour calculer un état de charge SOC d'une batterie sur la base d'un état de charge d'un côté de charge, le procédé comprenant :

   l'acquisition, lorsqu'une batterie à charger est en cours de charge, d'un paramètre électrique d'un composant électrique spécifique sur le côté de charge de la batterie à charger (S1) ;
   le calcul d'un SOC courant de la batterie à charger au moyen d'un modèle d'estimation préconstruit sur la base du paramètre électrique pour obtenir une distribution de probabilité postérieure du SOC courant de la batterie à charger (S2) ; et
   l'obtention du SOC de la batterie à charger sur la base de la distribution de probabilité postérieure du SOC courant de la batterie à charger (S3),
   dans lequel
   le modèle d'estimation est la distribution de probabilité postérieure de la batterie à charger en relation avec un courant de charge et le paramètre électrique du composant électrique spécifique sur le côté de charge ;
   **caractérisé en ce que**
   le paramètre électrique du composant électrique spécifique comprend le courant de charge, et une résistance entre une mise à la masse de protection et une protection de commande sur le côté de charge.

2. Procédé pour calculer le SOC de la batterie sur la base de l'état de charge du côté de charge selon la revendication 1, **caractérisé en ce que** le procédé pour construire le modèle d'estimation comprend :

   la construction d'un premier modèle de probabilité conditionnelle de courants de charge de la batterie à charger dans différents SOC et d'un second modèle de probabilité conditionnelle des paramètres électriques sur la base des courants de charge de la batterie à charger dans différents SOC et des paramètres électriques correspondants du composant électrique spécifique sur le côté de charge selon des données historiques ;
   l'acquisition des courants de charge de la batterie à charger dans différents SOC et des paramètres électriques sur la base des données historiques, et l'obtention d'une première probabilité antérieure et d'une seconde probabilité antérieure respectivement conformément au premier modèle de probabilité conditionnelle et au second modèle de probabilité conditionnelle ; et
   la construction de la distribution de probabilité postérieure de la batterie à charger en relation avec le courant de charge et le paramètre électrique du composant électrique spécifique sur le côté de charge au moyen d'une formule de Bayes sur la base de la première probabilité antérieure et de la seconde probabilité antérieure, et la considération de la distribution de probabilité postérieure en tant que modèle d'estimation.

3. Procédé pour calculer le SOC de la batterie sur la base de l'état de charge du côté de charge selon la revendication 2, **caractérisé en ce que** le procédé pour obtenir la première probabilité antérieure comprend en outre :

   la constitution de statistiques sur les distributions de SOC correspondant à des courants de charge de la batterie à charger depuis un état à charger jusqu'à un état complètement chargé ; et
   le calcul d'une distribution moyenne des distributions de SOC correspondant aux courants de charge, et la considération de la distribution moyenne en tant que première probabilité antérieure.

4. Procédé pour calculer le SOC de la batterie sur la base de l'état de charge du côté de charge selon la revendication 3, **caractérisé en ce que** le procédé pour construire la distribution de probabilité postérieure au moyen de la formule de Bayes comprend :

la substitution de la première probabilité antérieure et de la seconde probabilité antérieure à l'intérieur de la formule de Bayes pour construire la distribution de probabilité postérieure, dans lequel la formule de Bayes est spécifiquement comme suit :

$$P(B_i|A) = \frac{P(B_i)P(A|B_i)}{\sum_{j=1}^{n} P(B_j)P(A|B_j)}$$

dans laquelle $P(B_i)$ est la première probabilité antérieure, $P(A|B_i)$ est la seconde probabilité antérieure, la variable $B_i$ est l'information de SOC de la batterie à charger, la variable A est le paramètre électrique du composant électrique spécifique et la variable n est un seuil prédéfini du SOC de la batterie à charger qui est obtenu après quantification discrète.

5. Procédé pour calculer le SOC de la batterie sur la base de l'état de charge du côté de charge selon la revendication 1, **caractérisé en ce que** le procédé pour « obtenir le SOC de la batterie à charger sur la base de la distribution de probabilité postérieure du SOC courant de la batterie à charger (S3) » comprend :
le calcul d'une espérance mathématique ou d'une estimation de vraisemblance maximum d'une distribution de densité de probabilité postérieure du SOC courant de la batterie à charger, et la considération d'un résultat de calcul en tant que SOC de la batterie à charger.

6. Procédé pour calculer le SOC de la batterie sur la base de l'état de charge du côté de charge selon la revendication 1, **caractérisé en ce que** le procédé pour acquérir le courant de charge comprend :
l'obtention, par une extrémité de réception de signal PWM sur le côté de charge, du courant de charge en analysant un signal PWM de la batterie à charger.

7. Procédé pour calculer le SOC de la batterie sur la base de l'état de charge du côté de charge selon l'une quelconque des revendications 1 à 6, **caractérisé en ce que**, avant ladite construction de la distribution de probabilité postérieure au moyen d'une formule de Bayes sur la base de la première probabilité antérieure et de la seconde probabilité antérieure, le procédé comprend en outre :

l'introduction d'un type de véhicule de la batterie à charger à l'intérieur du paramètre électrique, et l'ajout du type de véhicule de la batterie à charger en tant que variable à la formule de Bayes, dans lequel la formule de Bayes obtenue après que le type de véhicule est ajouté est spécifiquement comme suit :

$$P(B_i, C|A) = \frac{P(B_i, C)P(A|B_i, C)}{\sum_{i=1}^{k} \sum_{j=1}^{n} P(B_j, C_i)P(A|B_j, C_i)}$$

dans laquelle la variable C est le type de véhicule de la batterie à charger, et la variable k est une somme des types de véhicule des batteries à charger.

8. Système pour calculer un SOC d'une batterie sur la base d'un état de charge d'un côté de charge, comprenant :

une unité d'acquisition d'information (1) configurée pour acquérir, lorsqu'une batterie à charger est en cours de charge, un paramètre électrique d'un composant électrique spécifique sur le côté de charge de la batterie à charger ;
une unité de calcul de SOC (2) configurée pour calculer un SOC courant de la batterie à charger au moyen d'un modèle d'estimation préconstruit sur la base du paramètre électrique pour obtenir une distribution de probabilité postérieure du SOC courant de la batterie à charger ; et pour obtenir une information de SOC de la batterie à charger sur la base de la distribution de probabilité postérieure du SOC courant de la batterie à charger ; et

une unité d'émission de données (3) configurée pour émettre l'information acquise par l'unité d'acquisition d'information (1) sur l'unité de calcul de SOC (2) et pour émettre l'information de SOC calculée par l'unité de calcul de SOC (2) sur une pile de charge à courant alternatif/AC,

dans lequel le modèle d'estimation est la distribution de probabilité postérieure de la batterie à charger en relation avec un courant de charge et le paramètre électrique du composant électrique spécifique sur le côté de charge ;

**caractérisé en ce que**

le paramètre électrique du composant électrique spécifique comprend le courant de charge, et une résistance entre une mise à la masse de protection et une protection de commande sur le côté de charge.

9. Système pour calculer le SOC de la batterie à charger sur la base de l'état de charge du côté de charge selon la revendication 8, **caractérisé en ce que** le procédé pour construire le modèle d'estimation comprend :

la construction d'un premier modèle de probabilité conditionnelle de courants de charge de la batterie à charger dans différents SOC et d'un second modèle de probabilité conditionnelle des paramètres électriques sur la base des courants de charge de la batterie à charger dans différents SOC et des paramètres électriques correspondants du composant électrique spécifique sur le côté de charge selon des données historiques ;

l'acquisition des courants de charge de la batterie à charger dans différents SOC et des paramètres électriques sur la base des données historiques, et l'obtention d'une première probabilité antérieure et d'une seconde probabilité antérieure respectivement conformément au premier modèle de probabilité conditionnelle et au second modèle de probabilité conditionnelle ; et

la construction de la distribution de probabilité postérieure de la batterie à charger en relation avec le courant de charge et le paramètre électrique du composant électrique spécifique sur le côté de charge au moyen d'une formule de Bayes sur la base de la première probabilité antérieure et de la seconde probabilité antérieure, et la considération de la distribution de probabilité postérieure en tant que modèle d'estimation.

10. Dispositif de stockage sur lequel une pluralité de programmes sont stockés, **caractérisé en ce que** les programmes sont adaptés pour être chargés et exécutés par un processeur pour mettre en œuvre le procédé pour calculer le SOC de la batterie sur la base de l'état de charge du côté de charge selon l'une quelconque des revendications 1 à 7.

11. Dispositif de traitement, comprenant un processeur et un appareil de stockage ; le processeur étant adapté pour exécuter divers programmes ; et l'appareil de stockage étant adapté pour stocker une pluralité de programmes, **caractérisé en ce que** les programmes sont adaptés pour être chargés et exécutés par le processeur pour mettre en œuvre le procédé pour calculer le SOC de la batterie sur la base de l'état de charge du côté de charge selon l'une quelconque des revendications 1 à 7.

Step S1

Acquiring, when a battery to be charged is being charged, an electrical parameter of a specific electrical component on a charging side of the battery to be charged

Step S2

Calculating a current SOC of the battery to be charged by means of a pre-constructed estimation model on the basis of the electrical parameter to obtain a posterior probability distribution of the current SOC of the battery to be charged

Step S3

Obtaining SOC information of the battery to be charged on the basis of the posterior probability distribution of the current SOC of the battery to be charged

*Fig. 1*

*Fig. 2*

*Fig. 3*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 107064800 A
- KR 20160063070 A